Europäisches Patentamt

European Patent Office

Office européen des brevets

(19)

(11)  EP 1 421 579 B1

(12)  **EUROPEAN PATENT SPECIFICATION**

(45) Date of publication and mention
of the grant of the patent:
**05.04.2006  Bulletin 2006/14**

(51) Int Cl.:
*G10L 19/02* (2006.01)      *H04B 1/66* (2006.01)
*H04N 7/26* (2006.01)

(21) Application number: **02755519.2**

(22) Date of filing: **14.08.2002**

(86) International application number:
**PCT/IB2002/003316**

(87) International publication number:
**WO 2003/019532 (06.03.2003 Gazette 2003/10)**

(54) **AUDIO CODING WITH NON-UNIFORM FILTER BANK**

AUDIO KODIERER MIT UNREGELMÄSSIGER FILTERBANK

CODAGE AUDIO A BANC DE FILTRES NON-UNIFORME

(84) Designated Contracting States:
**AT BE BG CH CY CZ DE DK EE ES FI FR GB GR
IE IT LI LU MC NL PT SE SK TR**

(30) Priority: **21.08.2001 EP 01203161**

(43) Date of publication of application:
**26.05.2004  Bulletin 2004/22**

(73) Proprietor: **Koninklijke Philips Electronics, N.V.
5621 BA  Eindhoven (NL)**

(72) Inventors:
• **NIAMUT, Omar, A.**
**NL-5656 AA Eindhoven (NL)**
• **HEUSDENS, Richard**
**NL-5656 AA Eindhoven (NL)**

(74) Representative: **Groenendaal, Antonius W. M.
Philips
Intellectual Property & Standards
P.O. Box 220
5600 AE  Eindhoven (NL)**

(56) References cited:
• **MALVAR H: "Enhancing the performance of
subband audio coders for speech signals"
CIRCUITS AND SYSTEMS, 1998. ISCAS '98.
PROCEEDINGS OF THE 1998 IEEE
INTERNATIONAL SYMPOSIUM ON MONTEREY,
CA, USA 31 MAY-3 JUNE 1998, NEW YORK, NY,
USA,IEEE, US, 31 May 1998 (1998-05-31), pages
98-101, XP010289988 ISBN: 0-7803-4455-3 cited
in the application**
• **PAINTER T ET AL: "A review of algorithms for
perceptual coding of digital audio signals"
DIGITAL SIGNAL PROCESSING PROCEEDINGS,
1997. DSP 97., 1997 13TH INTERNATIONAL
CONFERENCE ON SANTORINI, GREECE 2-4
JULY 1997, NEW YORK, NY, USA,IEEE, US, 2 July
1997 (1997-07-02), pages 179-208, XP010251044
ISBN: 0-7803-4137-6**
• **MOON HO LEE ET AL: "The design of
multidimensional filter bank using reverse jacket
matrix" TENCON 99. PROCEEDINGS OF THE
IEEE REGION 10 CONFERENCE CHEJU ISLAND,
SOUTH KOREA 15-17 SEPT. 1999, PISCATAWAY,
NJ, USA,IEEE, US, 15 September 1999
(1999-09-15), pages 637-641, XP010368257 ISBN:
0-7803-5739-6**

**Description**

The present invention relates to coding and decoding audio signals.

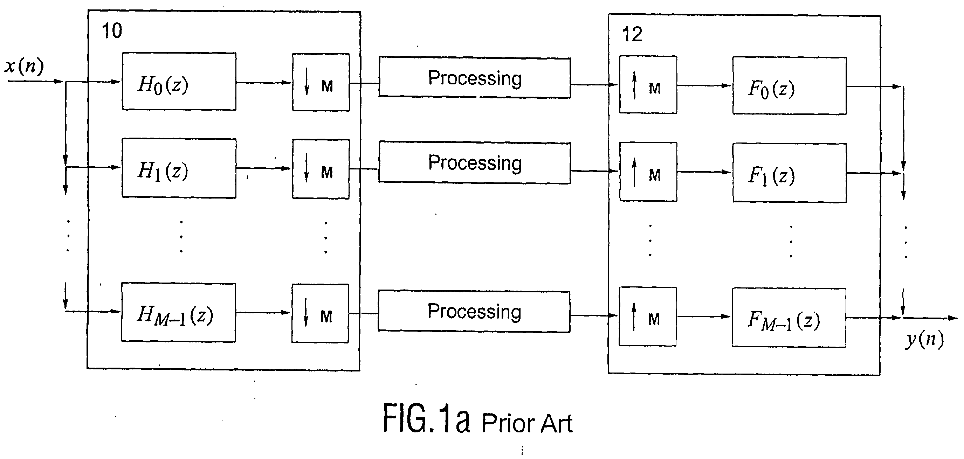

Figure 1 (a) shows a basic block diagram for a system including a conventional M-channel analysis filter bank 10 and a synthesis filter bank 12. The analysis filter bank comprises a collection of digital filters $H_k(z)$, $k=0,...,M-1$ each with an associated output channel and a common input $x(n)$. The synthesis filter bank comprises a collection of filters $F_k(z)$ each with an associated input channel and a common output $y(n)$. In the analysis filter bank 10, each channel is decimated by a factor M and in the synthesis filter bank 12, it is interpolated by a factor M. If the degree of interpolation is equal to the degree of decimation, as in the example, the filter bank is critically sampled and if all the filters have the same bandwidth, the filter bank is a uniform filter bank.

The M-channels output by the analysis filter bank 10 can be processed in any number of ways. For example, if the analysis filter bank 10 forms part of an audio encoder, then for a given update interval, the channel data and possibly the filter bank structure can be encoded in a bitstream representing the audio signal $x(n)$. If the synthesis filter bank 12 forms part of an audio decoder, then the synthesis filter bank structure are combined with the channel data to generate the signal y(n). Alternatively, both banks 10, 12 may be included in an audio processing system where, for example, the signal $x(n)$ is subjected to some form of post-processing with the processed signal $y(n)$ being stored on a storage medium or relayed on a transmission medium.

In a cosine-modulated filter (CMF) bank, the analysis and synthesis filters are cosine-modulated versions of a single prototype filter. A known formula for the analysis and synthesis filters is:

$$h_k(n) = 2p_0(n)\cos[\frac{(2k+1)}{2M}\pi n + \varepsilon_k],$$
$$f_k(n) = 2p_0(n)\cos[\frac{(2k+1)}{2M}\pi n + \gamma_k], \quad k = 0,...,M-1$$

where

$$\varepsilon_k = -\frac{\pi}{2M}(2k+1)\frac{\alpha}{2} + \frac{\pi}{2}\beta \text{ and } \gamma_k = \frac{\pi}{2M}(2k+1)\frac{\alpha}{2} + \frac{\pi}{2}\beta$$

where $\alpha \in Z$ is the modulation phase and $\beta=0$ for cosine modulation and $\beta=1$ for sine modulation.

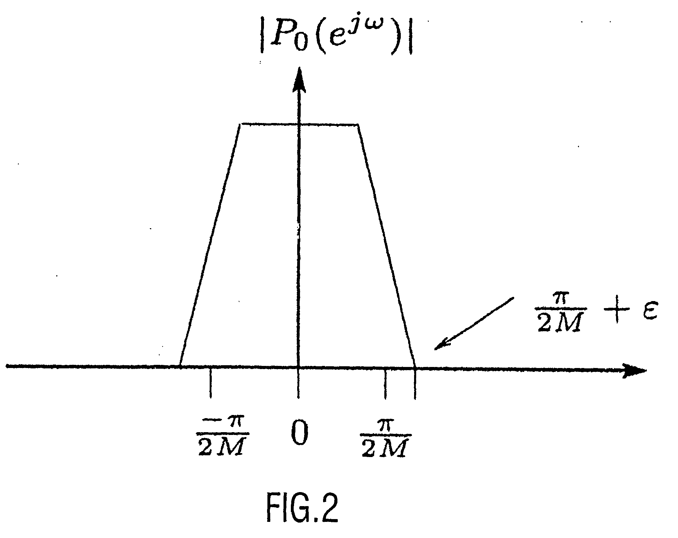

It is known to employ uniform CMF banks, some-times called pseudo-QMF (Quadrature Mirror Filter) banks or modulated lapped transforms in applications such as the coding of digital signals. The term perfect reconstruction (PR) is applied to filter banks where the output $y(n)$ is a scaled and delayed version of the input $x(n)$. The theory for the design of PR uniform CMF banks is well established, and in the above case, the PR property can be satisfied by suitable choices of $\alpha$ and the prototype filter Po. For the purposes of the present description, an exemplary Po is a real-coefficient linear-phase low-pass filter of length N with a passband in $[-\frac{\pi}{2M} + \varepsilon, \frac{\pi}{2M} - \varepsilon]$ for $\varepsilon < \frac{\pi}{2M}$ and an infinitely attenuated stop-band, see Figure 2, that is:

$$|P_0(e^{j\omega})| = 0 \qquad \text{for } |\omega| \geq \frac{\pi}{2M} + \varepsilon, \varepsilon < \frac{\pi}{2M}$$

Some applications demand the use of non-uniform filter banks, i.e. filter banks where the filters have varying bandwidths. For example, in audio coding, it is desireable to provide filter banks that can adapt to the time-frequency energy distribution and characteristics of the input signal. The design of non-uniform filter banks is in general quite complex, but some recent methods allow for the design of non-uniform CMF banks,

For example, H.S. Malvar, "Biorthogonal and non-uniform lapped transforms for transform coding with reduced blocking and ringing artefacts," IEEE Trans. Signal Processing, vol. 46, no. 4, pp. 1043-1053, April 1998; and H.S. Malvar, "Enhancing the performance of sub-band audio coders for speech signals," in Proc. Int. Symp. Circuits and Systems '98, nn. 90-101, June 1998; and US Patent No. 6,115,689; Malvar disclose a method for constructing non-uniform modulated lapped transforms (MLT). This involves combining sub-band filters of a uniform MLT and will be referred to herein as sub-band merging. The combined sub-band filters have better time localization than the non-combined filters at the expense of a decrease in frequency localization. Since the non-uniform filter banks are obtained by simply taking linear combinations of the filters of a uniform MLT, the method allows for an efficient implementation of time-varying transforms. Malvar discloses that sub-band merging can be used beneficially for reducing ringing artefacts, e.g. reverberation and pre-echo, in audio and speech coding. The design of such transforms, however, is restricted in several ways: Only 2 or 4 subband filters can be combined and only a fixed number of pairs of high-frequency coefficients is combined, i.e. 16a2 filters, 8x4 filters. Furthermore no systematic design procedure is disclosed. In particular, in the case of combined 4 sub-band filters a difficult set of parameters is chosen to provide the required output.

According to the present invention there is provided a method according to claim 1.

The present invention provides a sub-band merging method which allows an arbitrary number of sub-bands to be combined in a systematic way. The preferred embodiments show that starting from a uniform CMF bank, linear combinations of the constituent filters can be taken such that the resulting combined filters have good frequency selective properties and flat pass-band response.

Embodiments of the invention will now be described with reference to the accompanying drawings, in which:

Figure 1 (a) is a block diagram of a conventional analysis/synthesis filter bank;
Figure 1 (b) is a block diagram of an analysis/synthesis filter bank according to a preferred embodiment of the invention;
Figure 2 illustrates the characteristics of a prototype filter Po employed in the preferred embodiment of the invention;
Figures 3(a) and (b) compare time-domain responses of a filter bank of the preferred embodiment with those of a prior art filter bank (a) refers to prior art, (b) to preferred embodiment;
Figures 4(a) and (b) compare magnitude responses of a filter bank of the preferred embodiment with those of a prior art filter bank (a) refers to prior art, (b) to preferred embodiment; and
Figure 5 shows a practical embodiment of a filter bank according to the present invention.

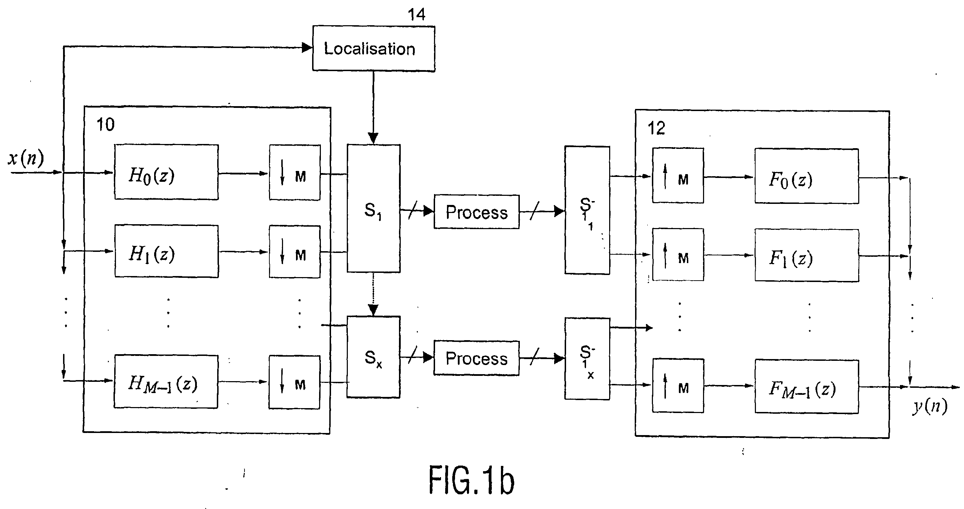

In a preferred embodiment of the present invention, Figure 1(b), an M-channel maximally decimated uniform CMF bank 10, 12 comprises filters $H_k(z)$, $F_k(Z)$ derived by cosine modulation of a single prototype filter Po ideally as illustrated in Figure 2. A localisation module 14 determines from an analysis of the time-frequency energy distribution and signal characteristics of the signal x($n$) in a given time interval, that it is preferable to de-localise frequency segmentation in favour of increased time resolution to provide improved encoded signal quality. (Alternatively the module 14 may determine that a lowering of overall bit-rate may be possible while maintaining the same level of quality if frequency segmentation is de-localised.)

Thus, in the example of Figure 1(b), the module 14 determines that x groups of filters comprising any number $p \le M$ adjacent filters in the uniform CMF bank are to be combined in segmentation matrices $S_1...S_x$ to provide a non-uniform filter bank.

(Although not necessary for the present invention it is presumed in the present description that a total of M output channels are produced after segmentation.) The encoded signal including channel data and indications of the frequency segmentation to be employed in any given time interval is decoded in inverse segmentation matrices $S^{-1}_1$ $S^{-1}_x$ to provide inputs for a uniform synthesis filter bank 12.

For the non-uniform filter bank to have a suitable frequency response, the magnitude characteristics of its filters must exhibit good frequency selectivity and flat passband response. To illustrate that the invention provides these selectivity and response characteristics, we consider a merged filter $H_{p,k}(Z)$ to be a linear combination of $p$ adjacent filters starting from the $k^{th}$ filter in a uniform CMF bank, i.e.

$$H_{p,k}(z) = \sum_{i=0}^{p-1} b_{k+i} H_{k+i}(z), \qquad k = 0,...,M-p$$

with $b_k = e^{j\varphi_k}$ being the combinatorial coefficients of magnitude 1. If $|H_{p,k}(z)|^2$ (or equivalently $\left| \sum_{i=0}^{p-1} b_{k+i} H_{k+i}(z) \right|^2$)

is equal to $\sum_{i=0}^{p-1} | H_{k+i}(z) |^2$, then $H_{p,k}(z)$ has a flat passband response and a transition bandwidth similar to those of the underlying uniformly spaced sub-band filters. If the prototype filter satisfies the condition on the stopband reduction (as the exemplary Po), there is no spectral overlap between filters $H_k(z)$ and $H_l(z)$ for |k—1|≥2, so that

$$\sum_{i=0}^{p-1}| H_{k+i}(e^{j\omega})|^2 = c, \; c \neq 0, \text{ for } | \omega | \in [\frac{k\pi}{2M} + \varepsilon, \frac{(k+p)\pi}{2M} - \varepsilon]$$ and zero in its stopband.

It will nonetheless be seen that the prototype filter Po can't be implemented in practical applications since it requires infinite length filters. Therefore, in practical situations, overlapping terms in the frequency domain of non-adjacent filters do exist and result in ripples in the passband of the combined filters. However, by keeping the stop-band attenuation of the prototype filter high, these ripples are kept to a minimum.

The following gives necessary and sufficient conditions on the modulation phase (i.e. on the uniform filter bank) and the combinatorial coefficients such that the resulting combined filters indeed exhibit the required frequency behaviour.

For the prototype filter Po of Figure 2 and $b_k = e^{j\varphi_k}$, $k = 0,...,M - 1$, we then have

$$| \sum_{i=0}^{p-1} b_{k+i}H_{k+i}(z)|^2 = \sum_{i=0}^{p-1}| H_{k+i}(z)|^2$$ for $1 \leq p \leq M$ and $0 \leq k \leq M-p$, if and only if $\alpha = (N-1)-M(2m+1)$, $m \in Z$, and

$|\varphi_k - \varphi_{k+1}| = n\pi$, $n \in \aleph$ .

It may be seen that the condition on $\alpha$ is a new restriction on the under-lying uniform CMF bank, but this is not the case. Most CMF banks known from literature satisfy the condition on $\alpha$ since it cancels first-order aliasing and magnitude distortion at $\omega \in \{0,\pi\}$. As for the condition on $b_k$, this amounts to choosing combinatorial coefficients of magnitude 1 that can only differ in sign.

The combination operation can be represented by a matrix multiplication. Consider the example in which two filters (p = 2) are combined. If we define a matrix A containing the impulse responses of the analysis filters of the uniform CMF bank as:

$$A = \begin{pmatrix} h_0(0) & \cdots & h_0(N-1) \\ \vdots & \ddots & \vdots \\ h_{M-1}(0) & \cdots & h_{M-1}(N-1) \end{pmatrix} \in C^{MxN}$$

a matrix A' which contains the impulse responses of the analysis filters of the non-uniform CMF bank can be created by the matrix multiplication A' = SA, where

$$S = \begin{pmatrix} 1 & & & & & \\ & \ddots & & & \varnothing & \\ & & 1 & 1 & & \\ & & 1 & -1 & & \\ & \varnothing & & & \ddots & \\ & & & & & 1 \end{pmatrix} \in C^{MxM}$$

The combinatorial coefficients $b_k$ are found in the rows of the block-diagonal element of S, which in this case is a size 2 Hadamard matrix - a non-singular matrix.

In the case p> 2, the non-singular block-diagonal element in S is of size p x p having entries $\pm$ 1. In the preferred embodiment, such a non-singular matrix is the p x p principal sub-matrix of a size N≥p Hadamard matrix.

Thus, according to the present invention, PR non-uniform CMF banks representing a desired filter bank structure can be provided in an encoder through a matrix multiplication of the component filters and non-singular blocks from Hadamard matrices.

In the decoder, for $p = 2^n$, $n \in \aleph$, the segmented signal A'=SA can be multiplied by the transpose $S^T$ of the matrix S to provide a scaled version of the original signal. Thus, the transform AS $\rightarrow S^T$ A' can be made unitary (orthonormal) by scaling the combinatorial coefficients $b_k$ properly, so that, assuming the original uniform filter bank is unitary, the non-uniform filter bank is unitary as well. For example, for p=4 the matrix S is:

$$\begin{pmatrix} 1 & 1 & 1 & 1 \\ 1 & -1 & 1 & -1 \\ 1 & 1 & -1 & -1 \\ 1 & -1 & -1 & 1 \end{pmatrix}$$

Multiplying this by its transpose provides an identity matrix with element magnitudes of 4 and so in this case a coefficient $b_k=1/2$ should be used for a unitary system. Similarly, for p=2, $b_k = 1/\sqrt{2}$ should be used.

For $p \neq 2^n$, $n \in \aleph$ the inverse rather than transpose matrix must be used in the synthesis operation so that $SS^{-1}$ gives the identity matrix. (As such this is not as computationally efficient as when $p = 2^n$)

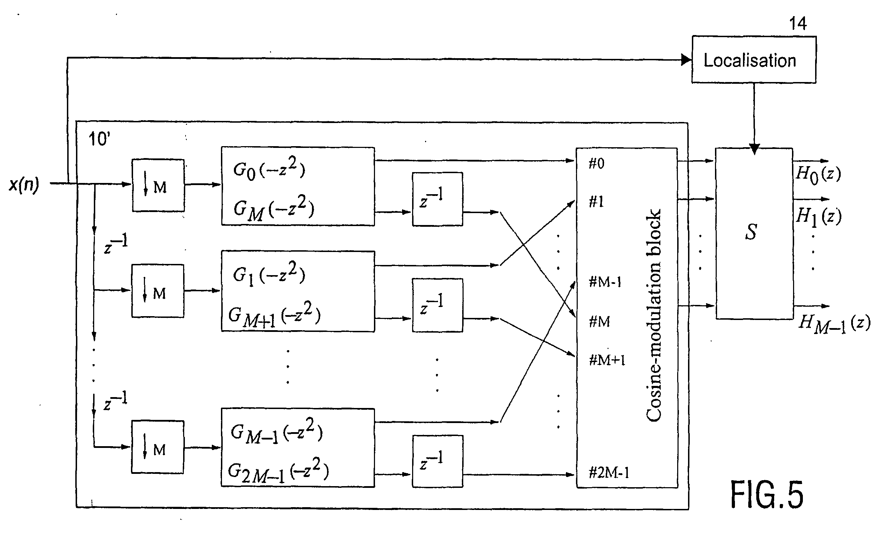

The segmentation matrices S, $S^{-1}$ can be implemented cascaded to any uniform filter bank. For example, Figure 5 illustrates an analysis filter bank 10' of the form employed in an MPEG encoder. In this case, the input signal $x(n)$, is connected through a tapped delay line with each successively delayed signal being decimated by a factor M. By comparison to the schema shown in Figures 1(a) and (b) this schema means that only decimated signals are filtered rather than vice versa. The decimated signals are filtered by respective pairs of filter functions $G_m(-z^2)$ and their outputs are cross-linked within a cosine modulation module which produces M output channels.

As in the case of Figure 1(b), where a localisation module 14 determines that frequency de-localisation in a given sub-band will improve the quality of response by improving time resolution, then one or more groups of adjacent filter output channels are combined accordingly within the segmentation matrix system S which comprises one or more principle submatrices of Hadamard matrices as described above.

Thus, for any update interval, groups of these filter output channels can be segmented to combine individual filters and so de-localise frequency selection but at the same time increase the time resolution of the bitstream. Specific methods employed by the localisation module 14 for determining the optimum time-frequency segmentation are beyond the scope of the present specification but some are discussed for example in Malvar. In general, however, these involve a cost function balancing distortion against the bit-rate and can be applied to frequency segmentation alone or in combination with an adaptive time segmentation system.

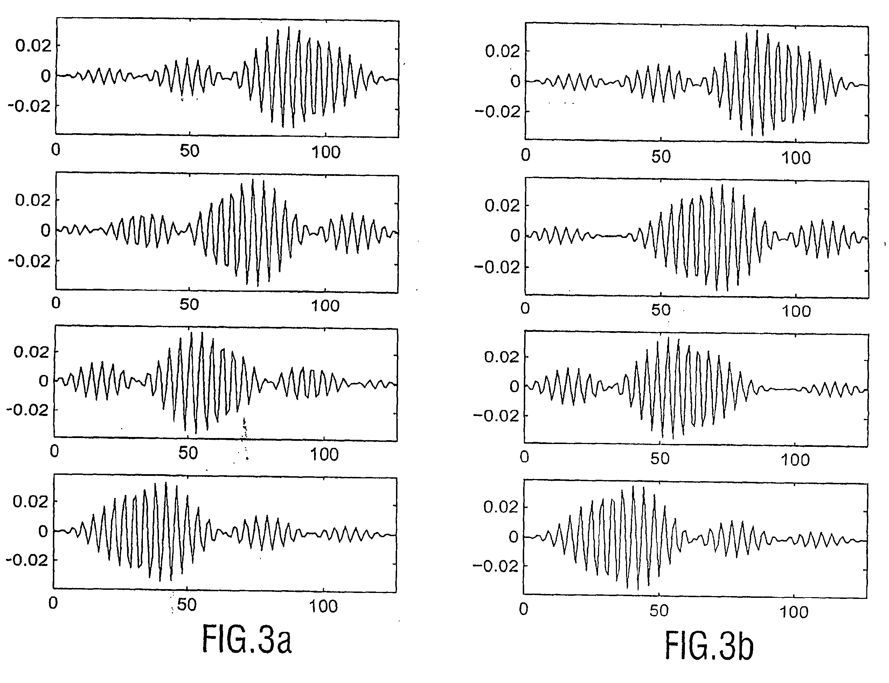

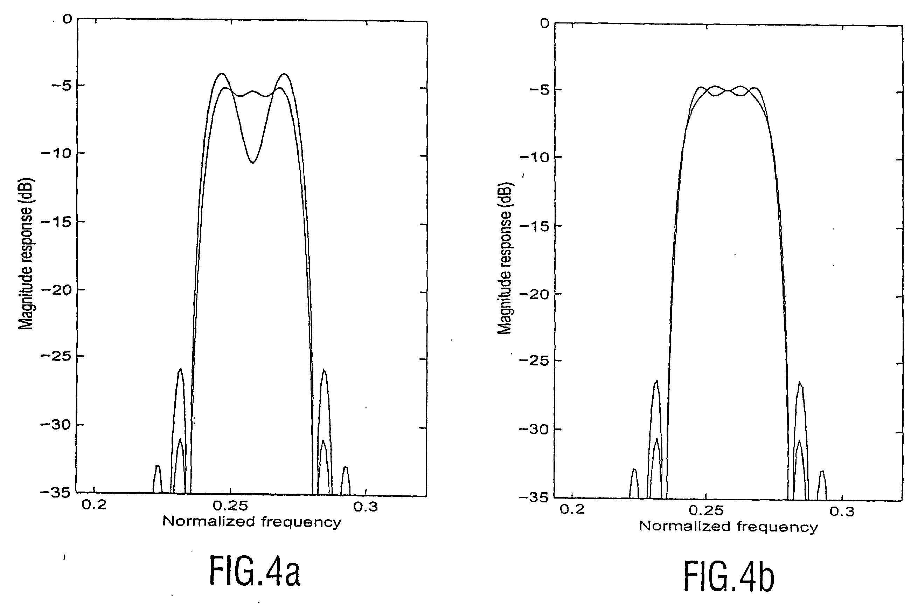

In order to compare the results of filter banks merged according to the invention to filter banks disclosed in Malvar, 4 sub-band filters are combined in a 64-channel MLT. The resulting time and frequency responses of the combined filters are shown in Figure 3 and 4, respectively. Figure 3(a) and 4(a) show results disclosed in Malvar while Figures 3(b) and 4(b) show results for the present invention. By inspection of the figures, it can be seen that for comparable time localization, the present invention gives better frequency responses.

Thus, where a comparable level of quality is required with respect to, for example, Malvar, an audio encoder including the segmentation matrices according to the preferred embodiment of the present invention, can lower its bit-rate so saving in overall bandwidth. Alternatively, improved quality will be provided for the same bit-rate.

**Claims**

1. A method of encoding an audio signal $(x(n))$, the method comprising the steps of:

   providing said signal $(x(n))$ as an input to a uniform analysis filter bank (10), said analysis filter bank comprising a plurality of cosine modulated filters $(H_k(z))$, each filter providing a respective output signal;
   determining (14) a non-uniform segmentation of said analysis filter bank wherein at least one group of three or more filters are to be combined for at least one time interval of said audio signal;
   combining said at least one group of filters with a respective segmentation matrix $(S_1...S_x)$, each matrix comprising a pxp principal submatrix of a Hadamard matrix, where p is equal to the number of filters to be combined in a group; and
   encoding the output of said filters and said segmentation matrices and respective indications of said segmentation in a bitstream.

2. A method according to claim 1 further comprising the step of:

   multiplying the coefficients of each Hadamard matrix by a combinatorial coefficient $(b_k)$ so that said matrix combination is orthonormal.

3. A method of decoding a bit stream, the method comprising the steps of

reading said bit stream to provide a plurality of data channels corresponding to frequency bands in a non-uniform synthesis filter bank;

determining from said bit stream a non-uniform segmentation of said synthesis filter bank wherein at least one group of three or more data channels are to be combined for at least one time interval of said bit stream;

combining said at least one group of data channels with a respective segmentation matrix ($S^{-1}_1...S^{-1}_x$), each matrix comprising a pxp principal submatrix of a Hadamard matrix, where p is equal to the number of filters to be combined in a group; and

providing the output of said at least one combinations as respective channel inputs to a uniform synthesis filter bank (12) comprising a plurality of cosine modulated filters *($F_k(z)$)* said filters providing a common output signal *(y(n))*.

4. A method according to claim 3 wherein p is equal to an integer power of two and wherein each segmentation matrix comprises a transpose of a pxp Hadamard matrix.

5. A method according to claim 3 wherein p is not equal to an integer power of two and wherein each segmentation matrix comprises an inverse of a pxp Hadamard matrix.

6. A method according to claims 4 or 5 further comprising the step of:

multiplying the coefficients of each Hadamard matrix by a combinatorial coefficient ($b_k$) so that said matrix combination is unitary.

7. Audio coder, comprising:

means for providing an audio signal (*x(n)*) as an input to a uniform analysis filter bank (10), said analysis filter bank comprising a plurality of cosine modulated filters (*$H_k(z)$*), each filter providing a respective output signal;

means for determining (14) a non-uniform segmentation of said analysis filter bank wherein at least one group of three or more filters are to be combined for at least one time interval of said audio signal;

means for combining said at least one group of filters with a respective segmentation matrix ($S_1...S_x$), each matrix comprising a pxp principal submatrix of a Hadamard matrix, where p is equal to the number of filters to be combined in a group; and

an encoder for providing the output of said filters and said segmentation matrices and respective indications of said segmentation in a bitstream.

8. Audio player, comprising:

means for reading a bit stream to provide a plurality of data channels corresponding to frequency bands in a non-uniform synthesis filter bank;

means for determining from said bit stream a non-uniform segmentation of said synthesis filter bank wherein at least one group of three or more data channels are to be combined for at least one time interval of said bit stream;

means for combining said at least one group of data channels with a respective segmentation matrix ($S^{-1}_1...S^{-1}_x$), each matrix comprising a pxp principal submatrix of a Hadamard matrix, where p is equal to the number of filters to be combined in a group; and

means for providing the output of said at least one combinations as respective channel inputs to a uniform synthesis filter bank (12) comprising a plurality of cosine modulated filters *($F_k(z)$)* said filters providing a common output signal (*v*(n)).

9. Audio system comprising an audio coder as claimed in claim 7 and an audio player as claimed in claim 8.

10. Bit stream comprising data for a plurality of channels corresponding to frequency bands in a non-uniform synthesis filter bank comprising a plurality of cosine modulated filters *($F_k(z)$)*; and an indication of a non-uniform segmentation of said synthesis filter bank wherein at least one group of three or more data channels are to be combined for at least one time interval of said bit stream with a respective segmentation matrix ($S^{-1}_1...S^{-1}_x$), each matrix comprising a pxp Hadamard matrix, where p is equal to the number of filters to be combined in a group.

11. Storage medium on which a bit stream as claimed in claim 10 has been stored.

**Patentansprüche**

1. Verfahren zum Kodieren eines Audiosignals (x(n)), wobei das Verfahren die Schritte umfasst:

Bereitstellen des Signals (x(n)) als eine Eingabe in eine gleichförmige Analysefilterbank (10), wobei die Analysefilterbank eine Anzahl von kosinusmodulierten Filtern ($H_k(z)$) umfasst, wobei jeder Filter ein jeweiliges Ausgabesignal bereitstellt;
Bestimmen (14) einer ungleichförmigen Segmentierung der Analysefilterbank, wobei mindestens eine Gruppe von drei oder mehr Filtern für mindestens ein Zeitintervall des Audiosignals zu kombinieren ist;
Kombinieren der mindestens einen Gruppe von Filtern mit einer jeweiligen Segmentierungsmatrix ($S_1...S_x$), wobei jede Matrix eine p x p-Hauptuntermatrix einer Hadamardschen Matrix umfasst, wobei p gleich der Anzahl der in einer Gruppe zu kombinierenden Filter ist; und
Kodieren der Ausgabe der Filter und der Segmentierungsmatrizen und jeweiliger Hinweise auf die Segmentierung im Bitstrom.

2. Verfahren nach Anspruch 1, das außerdem den Schritt umfasst:

Multiplizieren der Koeffizienten jeder Hadamardschen Matrix mit einem kombinatorischen Koeffizienten ($b_k$), so dass die Matrixkombination orthonormal ist.

3. Verfahren zum Dekodieren eines Bitstroms, wobei das Verfahren die Schritte umfasst:

Lesen des Bitstroms, um eine Anzahl von Datenkanälen bereitzustellen, die Frequenzbändern in einer ungleichförmigen Synthesefilterbank entsprechen;
Bestimmen einer ungleichförmigen Segmentierung der Synthesefilterbank aus dem Bitstrom, wobei mindestens eine Gruppe von drei oder mehr Datenkanälen für mindestens ein Zeitintervall des Bitstroms zu kombinieren ist;
Kombinieren der mindestens einen Gruppe von Datenkanälen mit einer jeweiligen Segmentierungsmatrix ($S^{-1}_1...S^{-1}_x$), wobei jede Matrix eine p x p-Hauptuntermatrix einer Hadamardschen Matrix umfasst, wobei p gleich der Anzahl der in einer Gruppe zu kombinierenden Filter ist; und
Bereitstellen der Ausgabe der mindestens einen Kombination als jeweilige Kanaleingaben in eine gleichförmige Synthesefilterbank (12), die eine Anzahl von kosinusmodulierten Filtern ($F_k(z)$) umfasst, wobei die Filter ein gemeinsames Ausgabesignal (y(n)) bereitstellen.

4. Verfahren nach Anspruch 3, wobei p gleich einer ganzzahligen Potenz von zwei ist und wobei jede Segmentierungsmatrix eine Transponierte einer Hadamardschen Matrix p x p umfasst.

5. Verfahren nach Anspruch 3, wobei p nicht gleich einer ganzzahligen Potenz von zwei ist und wobei jede Segmentierungsmatrix eine Inverse einer Hadamardschen Matrix p x p umfasst.

6. Verfahren nach Anspruch 4 oder 5, außerdem den Schritt umfassend:

Multiplizieren der Koeffizienten jeder Hadamardschen Matrix mit einem kombinatorischen Koeffizienten ($b_k$), so dass die Matrixkombination unitär ist.

7. Audiokodierer, umfassend:

Mittel zum Bereitstellen eines Audiosignals (x(n)) als eine Eingabe in eine gleichförmige Analysefilterbank (10), wobei die Analysefilterbank eine Anzahl von kosinusmodulierten Filtern ($H_k(z)$) umfasst, wobei jeder Filter ein jeweiliges Ausgabesignal bereitstellt;
Mittel zum Bestimmen (14) einer ungleichförmigen Segmentierung der Analysefilterbank, wobei mindestens eine Gruppe von drei oder mehr Filtern für mindestens ein Zeitintervall des Audiosignals zu kombinieren ist;
Mittel zum Kombinieren der mindestens einen Gruppe von Filtern mit einer jeweiligen Segmentierungsmatrix ($S_1...S_x$), wobei jede Matrix eine p x p-Hauptuntermatrix einer Hadamardschen Matrix umfasst, wobei p gleich der Anzahl der in einer Gruppe zu kombinierenden Filter ist; und
einen Kodierer zum Bereitstellen der Ausgabe der Filter und der Segmentierungsmatrizen und jeweiliger Hinweise auf die Segmentierung im Bitstrom.

8.  Audioplayer, umfassend:

    Mittel zum Lesen eines Bitstroms, um eine Anzahl von Datenkanälen bereitzustellen, die den Frequenzbändern in einer ungleichförmigen Synthesefilterbank entsprechen;
    Mittel zum Bestimmen einer ungleichförmigen Segmentierung der Synthesefilterbank aus dem Bitstrom, wobei mindestens eine Gruppe von drei oder mehr Datenkanälen für mindestens ein Zeitintervall des Bitstroms zu kombinieren ist;
    Mittel zum Kombinieren der mindestens einen Gruppe von Datenkanälen mit einer jeweiligen Segmentierungsmatrix ($S^{-1}_1 ... S^{-1}_x$), wobei jede Matrix eine p x p-Hauptuntermatrix einer Hadamardschen Matrix umfasst, wobei p gleich der Anzahl der in einer Gruppe zu kombinierenden Filter ist; und
    Mittel zum Bereitstellen der Ausgabe der mindestens einen Kombination als jeweilige Kanaleingaben in eine gleichförmige Synthesefilterbank (12), die eine Anzahl von kosinusmodulierten Filtern ($F_k(z)$) umfasst, wobei die Filter ein gemeinsames Ausgabesignal ($y(n)$) bereitstellen.

9.  Audiosystem, einen Audiokodierer nach Anspruch 7 und einen Audioplayer nach Anspruch 8 umfassend.

10. Bitstrom, der Daten für eine Anzahl vom Kanälen umfasst, die Frequenzbändern in einer ungleichförmigen Synthesefilterbank entsprechen, welche eine Anzahl von kosinusmodulierten Filtern ($F_k(z)$) umfasst; und einen Hinweis auf eine ungleichförmige Segmentierung der Synthesefilterbank, wobei mindestens eine Gruppe von drei oder mehr Datenkanälen für mindestens ein Zeitintervall des Bitstroms mit einer jeweiligen Segmentierungsmatrix ($S^{-1}_1...S^{-1}_x$) zu kombinieren ist, wobei jede Matrix eine p x p-Hauptuntermatrix einer Hadamardschen Matrix umfasst, wobei p gleich der Anzahl der in einer Gruppe zu kombinierenden Filter ist.

11. Speichermedium, in dem ein Bitstrom gemäß Anspruch 10 gespeichert ist.

**Revendications**

1.  Procédé de codage d'un signal audio ($x(n)$), le procédé comprenant les étapes suivantes :

    fournir ledit signal ($x(n)$) en tant que signal d'entrée à un banc de filtres d'analyse uniforme (10), ledit banc de filtres d'analyse comprenant une pluralité de filtres modulés en cosinus ($H_k(z)$), chaque filtre fournissant un signal de sortie respectif;
    déterminer (14) une segmentation non uniforme dudit banc de filtres d'analyse dans laquelle au moins un groupe de trois ou plus de trois filtres doit être combiné pendant au moins un intervalle de temps dudit signal audio,
    combiner ledit au moins un groupe de filtres avec une matrice de segmentation respective ($S_1...S_x$), chaque matrice comprenant une sous-matrice principale pxp d'une matrice de Hadamard, où p est égal au nombre de filtres à combiner en un groupe; et
    coder la sortie desdits filtres et desdites matrices de segmentation et les indications respectives de ladite segmentation en un train de bits.

2.  Procédé suivant la revendication 1, comprenant en outre l'étape suivante:

    multiplier les coefficients de chaque matrice de Hadamard par un coefficient combinatoire ($b_k$) de telle sorte que ladite combinaison de matrices soit orthonormale.

3.  Procédé pour décoder un train de bits, le procédé comprenant les étapes suivantes :

    lire ledit train de bits pour fournir une pluralité de canaux de données correspondant à des bandes de fréquences dans un banc de filtres de synthèse non uniforme;
    déterminer à partir dudit train de bits une segmentation non uniforme dudit banc de filtres de synthèse dans laquelle au moins un groupe de trois ou plus de trois canaux de données doit être combiné pendant au moins un intervalle de temps dudit train de bits;
    combiner ledit au moins un groupe de canaux de données avec une matrice de segmentation respective ($S^{-1}_1...S^{-1}_x$), chaque matrice comprenant une sous-matrice principale pxp d'une matrice de Hadamard, où p est égal au nombre de filtres à combiner en un groupe, et

fournir la sortie de ladite au moins une combinaison en tant que signaux d'entrée de canaux respectifs à un banc de filtres de synthèse uniforme (12) comprenant une pluralité de filtres modulés en cosinus ($F_k(z)$), lesdits filtres fournissant un signal de sortie commun ($y(n)$).

4. Procédé suivant la revendication 3, dans lequel p est égal à une puissance entière de deux et dans lequel chaque matrice de segmentation comprend une transposée d'une matrice pxp de Hadamard.

5. Procédé suivant la revendication 3 dans lequel p n'est pas égal à une puissance entière de deux et dans lequel chaque matrice de segmentation comprend une inverse d'une matrice pxp de Hadamard.

6. Procédé suivant la revendication 4 ou 5, comprenant en outre l'étape suivante :

   multiplier les coefficients de chaque matrice de Hadamard par un coefficient combinatoire ($b_k$) de telle sorte que ladite combinaison de matrices soit unitaire.

7. Codeur audio, comprenant :

   un moyen pour fournir un signal audio ($x(n)$) en tant que signal d'entrée à un banc de filtres d'analyse uniforme (10), ledit banc de filtres d'analyse comprenant une pluralité de filtres modulés en cosinus ($H_k(z)$), chaque filtre fournissant un signal de sortie respectif;
   un moyen pour déterminer (14) une segmentation non uniforme dudit banc de filtres d'analyse dans laquelle au moins un groupe de trois ou plus de trois filtres doit être combiné pendant au moins un intervalle de temps dudit signal audio;
   un moyen pour combiner ledit au moins un groupe de filtres avec une matrice de segmentation respective ($S_1...S^x$), chaque matrice comprenant une sous-matrice principale pxp d'une matrice de Hadamard, où p est égal au nombre de filtres à combiner en un groupe; et
   un codeur pour fournir la sortie desdits filtres et desdites matrices de segmentation ainsi que des indications respectives de ladite segmentation dans un train de bits.

8. Lecteur audio, comprenant :

   un moyen pour lire un train de bits en vue de fournir une pluralité de canaux de données correspondant à des bandes de fréquences dans un banc de filtres de synthèse non uniforme;
   un moyen pour déterminer à partir dudit train de bits une segmentation non uniforme dudit banc de filtres de synthèse dans laquelle au moins un groupe de trois ou plus de trois canaux de données doit être combiné pendant au moins un intervalle de temps dudit train de bits;
   un moyen pour combiner ledit au moins un groupe de canaux de données avec une matrice de segmentation respective ($S^{-1}_1...S^{-1}_x.$), chaque matrice comprenant une sous-matrice principale pxp d'une matrice de Hadamard, où p est égal au nombre de filtres à combiner en un groupe; et
   un moyen pour fournir la sortie de ladite au moins une combinaison en tant que signaux d'entrée de canaux respectifs à un banc de filtres de synthèse uniforme (12) comprenant une pluralité de filtres modulés en cosinus ($F_k(z)$), lesdits filtres fournissant un signal de sortie commun ($y(n)$).

9. Système audio comprenant un codeur audio suivant la revendication 7 et un lecteur audio suivant la revendication 8.

10. Train de bits comprenant des données pour une pluralité de canaux correspondant à des bandes de fréquences dans un banc de filtres de synthèse non uniforme comprenant une pluralité de filtres modulés en cosinus ($F_k(z)$); et une indication d'une segmentation non uniforme dudit banc de filtres de synthèse dans laquelle au moins un groupe de trois ou plus de trois canaux de données doit être combiné pendant au moins un intervalle de temps dudit train de bits avec une matrice de segmentation respective ($S^{-1}_1...S^{-1}_x$), chaque matrice comprenant une matrice de Hadamard pxp, où p est égal au nombre de filtres à combiner en un groupe.

11. Support de stockage sur lequel un train de bits suivant la revendication 10 a été stocké.

FIG.1a Prior Art

FIG.1b

EP 1 421 579 B1

FIG.2

FIG.3a

FIG.3b

FIG.4a

FIG.4b

EP 1 421 579 B1

FIG.5